# EUROPEAN PATENT SPECIFICATION

(11) **EP 1 130 630 B1**
(45) Date of publication and mention of the grant of the patent: **09.05.2012**
(21) Application number: 99935076.2
(22) Date of filing: 05.08.1999
(51) Int. Cl.: C09G 1/02, C09K 3/14, H01L 21/3105

(54) **ABRASIVE COMPOSITION FOR POLISHING LSI DEVICE**
POLIERPASTE ZUM POLIEREN EINES LSI
COMPOSITION ABRASIVE POUR LE POLISSAGE DE COMPOSANTS LSI

(30) Priority: 05.08.1998 JP 22199798; 28.12.1998 JP 37377798
(43) Date of publication of application: 05.09.2001
(73) Proprietor: SHOWA DENKO K.K., Tokyo 105-8518 (JP)
(72) Inventor: KIDO, Takanori, Shiojiri-shi, Nagano 399-6461 (JP); TSUJINO, Fumio, Shi ojiri-shi, Nagano 399-6461 (JP); ICHIKAWA, Kagetaka, Shiojiri-shi, Nagano 399-6461 (JP); UOTANI, Nobuo, Chiba-shi, Chiba 267-0056 (JP)
(74) Representative: Strehl Schübel-Hopf & Partner
(86) International application number: PCT/JP1999/004241
(87) International publication number: WO 2000/008678

(56) References cited:
- WO-A-97/11484
- WO-A-98/49723
- JP-A- 8 134 435
- JP-A- 10 152 673
- JP-A- 60 127 965

## Description

### Technical Field

The present invention relates to a polishing-material slurry that allows highly accurate surfaces to be obtained at high efficiency by polishing. More pecifically, the invention relates to a polishing-material slurry suitable for polishing steps on insulating films such as silicon dioxide films, silicon nitride films and organic films used in manufacturing processes for LSI devices.

### Background Art

With the recent remarkable progress in computer-related technology there have been, year by year, advancements in the integration of LSI devices, while the memory capacities of magnetic disks are constantly on the increase; one of the fundamental techniques on which this progress has been based is polishing processing.

In manufacturing processes for LSI devices, polishing techniques for interlayer insulating films have been introduced and are beginning to be employed in practice for the major object of alleviating the problem on depth of focus in the photolithography step that occurs with refinement of design rules. There are also being seen more and more applications of polishing processing techniques such as embedded metal polishing (the Damascene method) for formation of fine wiring and the Shallow Trench Isolation method aimed at achieving separation of elements on narrower surface areas than by the conventional LOCOS (Local Oxidation of Silicon) method, as indispensable elemental technologies for the manufacture of next generation LSI devices. In this field, which involves polishing to miniature elements and wiring structures, high accuracy of finished surfaces is of course a requirement, but high efficiency and stability of the polishing process is also desired. Polishing interlayer insulating film and Shallow Trench Isolation have been primarily studied using a slurry suspended silicon dioxide fine powder obtained by a gas phase method in an alkaline aqueous solution or a slurry suspended cerium oxide powder in water, whereas metal polishing has been primarily studied using a slurry suspended silicon dioxide powder, also obtained by a gas phase method, or aluminum oxide powder in water, with addition of an oxidizing agent such as iron nitrate or hydrogen peroxide. However, it has not yet been possible to achieve a level which satisfies all of the standpoints of surface-accuracy (or finishing level), polishing rate and stability of polishing rate. In order to achieve a high surface-accuracy it is necessary for the polishing-material particles to have a fineness on the order of submicrons, but smaller polishing-material particles generally result in a slower polishing rate. Thus, there has been a trade-off between surface-accuracy and polishing rate, and it has not generally been easy to achieve both.

Alkaline slurries suspended silicon dioxide fine powders have been used to achieve high surface-accuracy in polishing interlayer insulating film, which has been the most practiced method of polishing for LSI device manufacturing processes, but the low polishing rate has been an inconvenience. The polishing rate generally increases gradually from the start of polishing, tending to stabilize after the course of a given time of usually a few minutes or more; however, since the machining thickness is at most about 1 µm for polishing in LSI device manufacturing processes, the polishing time most often is on the order of a few minutes. In other words, since the polishing is completed within a start-up region wherein polishing rate is still unstable, a considerable burden has existed in detecting the end point.

In contrast, cerium oxide slurries are advantageous for achieving both surface-accuracy and polishing rate in polishing interlayer insulating film and Shallow Trench Isolation method, but the polishing rate tends to increase with longer polishing time as in the case of silica slurries, and since the higher polishing rate makes it more difficult to detect the end point, this has constituted an obstacle against their practical implementation.

In the Shallow Trench Isolation method, a silicon nitride film is situated under the silicon dioxide film to be polished so that polishing is carried out with the silicon nitride film as a stopper, and therefore it has been necessary to have a fast polishing rate for the silicon dioxide film and a slow polishing rate for the silicon nitride film, or in other words, to have a high "selectivity ratio" which is the value of the polishing rate for the silicon dioxide film divided by that for the silicon nitride film; however, a problem has existed in that both silicon dioxide slurries and cerium oxide slurries have "selectivity ratios" of as low as about 2-6.

WO 97/11484 A discloses ceria based abrasive particles having an average particle size of 0.5 µm fixed to a pad, wherein the ceria particles have been treated with a titanate coupling agent, and the release of some fixed abrasive particles into a slurry.

WO 98/49723 A is a document pursuant to Art. 54(3) EPC and discloses a ceria based abrasive pad having on its surface particles having been surface-treated with a coupling agent.

As explained above under "Background Art", it has been strongly desired to realize higher levels of both surface-accuracy and polishing rate, as well as stability of polishing rate, than is currently achieved in polishing steps on insulating films such as silicon dioxide films, silicon nitride films and organic films in manufacturing processes for LSI devices.

The present invention provides a polishing-material slurry that can overcome the problems referred to above.

### Disclosure of the Invention

The notations used in the following description are now specified :
- "wt %" means "weight per cent";
- the inch, which equals 25.4 mm, is noted ";
- one tenth is noted 0.1, instead of 0,1;
- one thousand is noted 1,000 instead of 1.000;
- one kg/cm2 equals 101300 Pa;
- one gf/cm2 equals 101 Pa.

As a result of diligent research aimed at solving the aforementioned problems, the present inventors have discovered a polishing-material slurry for polishing
LSI devices characterized by a polishing-material slurry containing water and cerium oxide in a concentration of 0.3 to 10 wt % which has been surface treated with a coupling agent, the maximum value being no greater than 5 µm and the average value being 0.01 to 1.0 µm in the secondary particle size distribution of the cerium oxide; the polishing-material slurry for polishing LSI devices characterized in that the primary crystal size of the cerium oxide is 0.005 to 0.5 µm; and the polishing-material slurry for polishing LSI devices characterized in that the coupling agent is at least one coupling agent selected from among silane coupling agents, titanate coupling agents, zirconate coupling agents, aluminum coupling agents and phosphate coupling agents.

In polishing steps for LSI device insulating films, polishing-material slurries using silicon dioxide as the abrasive grains and polishing-material slurries using manganese dioxide as the abrasive grains have been studied in addition to cerium oxide but, for the present invention, the abrasive grains have been limited to cerium oxide. According to the invention, minimal improvement in polishing performance is achieved when silicon dioxide or manganese dioxide is used as the abrasive grains, and it is not possible to reach a satisfactory level desired for polishing LSI device insulating films.

According to the invention it is possible to realize a high level of both surface-accuracy (or surface finishing level) and polishing rate, as well as stabilization of polishing rate, by creating a condition where the polishing-material particles are strongly held in a polishing-pad during polishing. The polishing-pad is entirely made of resin, and the main polishing-pads used in polishing steps for LSI devices that require high accuracy are dry independent pore-type polyurethane pads produced by casting or slicing (such as "IC1000" by Rodel, Inc.), or nonwoven types prepared by impregnating polyurethane into polyester fibers and dry-foaming (such as "Suba400" by Rodel, Inc.), or two-layer types that are laminates of these two types of pads (such as "IC1000/Suba400" by Rodel, Inc.). Fluorine resin-based pads are also being investigated. Thus, while the pad material is an organic compound, the abrasive grain material used for the invention, i.e. cerium oxide, is an inorganic compound. Surfaces of inorganic compounds such as metal oxides usually have low affinity for and are poorly compatible with the surfaces of organic compounds. It was therefore considered that if it were possible to increase the affinity between cerium oxide and the pad, a condition would be created where the cerium oxide would be strongly held in the polishing-pad, thus resulting in a greater percentage of the cerium oxide effectively acting on the working target and allowing improvement the polishing rate.

A generally effective means to increase the affinity between inorganic compound surfaces and organic compound surfaces which is publicly known is surface treatment with a coupling agent, but it is almost never applied to polishing-material slurries. Since surface treatment with coupling agents is a technique originally applied in fields requiring filling of organic materials with inorganic filler particles, its use is not readily imaginable and has not been considered for the widely employed polishing-material slurries composed mainly of water, that are the object of the present invention.

An example of a technique of applying surface treatment with a coupling agent in some form to a polishing-material slurry is described below, but it offers no teaching in regard to the concept of attempting to improve polishing rate by strengthening the affinity between the abrasive grains and the pad, for polishing-material slurries composed mainly of water which is the object of the present invention.

In Japanese Unexamined Patent Publication (Kokai) No. 60-127965 there is disclosed a composition prepared by reacting an inorganic compound powder with a coupling agent and dispersing it in an organic solvent. However, in limited applications where the dispersing medium is an organic solvent, it is very natural to treat the surface of the inorganic compound powder with a coupling agent, and this is therefore totally unrelated to the present invention where the dispersing medium is water.

It is overwhelmingly common to use water as the dispersing medium for polishing-material compositions. This is because water has a greater accelerating effect on polishing than organic solvents. When polishing glass, for example, the presence of water forms a hydrate layer on the glass surface which allows accelerated polishing, so that a high surface-accuracy can be obtained at a high polishing rate, whereas actual polishing-material compositions where the dispersing medium is an organic solvent have virtually no polishing power on glass. Even when polishing metals, high resolution surfaces at high polishing rates can be obtained when the metal surface undergoes hydrolysis in the presence of water, forming metal oxide layers or hydroxide layers. When an organic solvent instead of water is used as the dispersing medium, since the polishing rate is notably lower, this is not pertinent to the present invention, the object of which is to realize a high level of surface-accuracy and polishing rate. According to the preferred mode of the invention, organic solvents are substantially absent.

According to the invention there is also provided a polishing method for LSI devices, which comprises a step of polishing an LSI device using a polishing pad made of resin and a polishing-material slurry containing water and cerium oxide which has been surface-treated with a coupling agent, wherein the maximum value is no greater than 5 µm and the average value is 0.01 to 1.0 µm in the secondary particle size distribution of the cerium oxide. In this method, the LSI device has a silicon nitride film formed by CVD on a silicon substrate and a silicon dioxide film formed thereon by CVD, and the method comprises a step of polishing the silicon dioxide film using the polishing-material slurry, the pH of the slurry being 4 to 11, and using the silicon nitride as a stopper, wherein the ratio of the polishing rate for the silicon dioxide film to that for the silicon nitride film may be 10 or greater, and even 50 or greater.

### Best Mode for Carrying Out the Invention

The cerium oxide used for the invention will be explained first.

The degree of purity of the cerium oxide is preferably high purity, which may be 99 wt% or greater, and even more preferably 99.9 wt% or greater. If the purity is low, even washing of the LSI device after polishing will not be able to easily rid the surface of the LSI device of impurity elements that adversely affect the properties of the LSI device, and this will create the undesirable situation of increased product defects and poorer yields.

In the secondary particle size distribution of the cerium oxide, the maximum value is preferably no greater than 5 µm, more preferably no greater than 3 µm, and even more preferably no greater than 1 µm. It is not desirable for the maximum value to exceed 5 µm because this will tend to result in minute imperfections in the polished surface. Also, the average value in the secondary particle size distribution of the cerium oxide is preferably 0.01 to 1.0 µm, and more preferably 0.1 to 0.5 µm. This is because at less than 0.01 µm the polishing rate on insulating films such as silicon dioxide films, silicon nitride films and organic films will be reduced. On the other hand, it is preferably not over 1.0 µm because this will tend to result in minute imperfections in the polishing surface.

The primary crystal size of the cerium oxide is preferably 0.005 to 0.5 µm, and more preferably 0.02 to 0.2 µm. At less than 0.005 µm the polishing rate on insulating films such as silicon dioxide films, silicon nitride films and organic films will be notably reduced, while it is preferably not over 0.5 µm because this will tend to result in minute imperfections in the polishing surface.

The coupling agent used for the invention may be a silane coupling agent, titanate coupling agent, zirconate coupling agent, aluminum coupling agent, phosphate coupling agent, etc. As examples of silane coupling agents there may be mentioned vinyltrichlorosilane, 1,2-dichloroethyltrichlorosilane, 1-chloroethyltrichlorosilane, 2-chloroethyltrichlorosilane, ethyltrichlorosilane, 3,3,3-trifluoropropyltrichlorosilane, 2-cyanoethyltrichlorosilane, allyltrichlorosilane, 3-bromopropyltrichlorosilane, 3-chloropropyltrichlorosilane, n-propyltrichlorosilane, 3-cyanopropyltrichlorosilane, n-butyltrichlorosilane, isobutyltrichlorosilan, pentyltrichlorosilane, hexyltrichlorosilane, benzyltrichlorosilane, p-tolyltrichlorosilane, 6-trichlorosilyl-2-norbornane, 2-trichlorosilylnorbornane, heptyltrichlorosilane, 2-(4-cyclohexenylethyl)trichlorosilane, octyltrichlorosilane, chlorophenylethyltrichlorosilane, tetradecyltrichlorosilane, octadecyltrichlorosilane, eicosyltrichlorosilane, docosyltrichlorosilane, chloromethyltrimethoxysilane, methyltrimethoxysilane, mercaptomethyltrimethoxysilane, vinyltrimethoxysilane, ethyltrimethoxysilane, 3,3,3-trifluoropropyltrimethoxysilane, 2-cyanoethyltrimethoxysilane, 3-chloropropyltrimethoxysilane, 3-mercaptopropyltrimethoxysilane, 3-aminopropyltrimethoxysilane, 2-aminoethylaminomethyltrimethoxysilane, butyltrimethoxysilane, 3-trifluoroacetoxypropyltrimethoxysilane, 3-(aminoethylaminopropyl)trimethoxysilane, phenyltrimethoxysilane, 3-glycidoxypropyltrimethoxysilane, 3-allylaminopropyl-trimethoxysilane, hexyltrimethoxysilane, 3-morpholinopropyltrimethoxysilane, 3-piperazinopropyltrimethoxysilane, 3-[2-(2-aminoethylaminoethylamino)propyl]trimethoxysilane, 2-(3,4-epoxycyclohexyl)ethyltrimethoxysilane, 3-piperidino-propyltrimethoxysilane, 3-phenylaminopropyltrimethoxysilane, 3-cyclohexylaminopropyltrimethoxysilane, O,O'-diethyl-S-(2-triethoxysilylethyl)dithiophosphate, 3-benzylaminopropyl-trimethoxysilane, 3-methacryloxypropyltrimethoxysilane, methyltriethoxysilane, vinyltriethoxysilane, ethyltriethoxysilane, 3-chloropropyltriethoxysilane, propyltriethoxysilane, 3-aminopropyltriethoxysilane, 2-(2-aminoethylthioethyl)triethoxysilane, pentyltriethoxysilane, 4-chlorophenyltriethoxysilane, phenyltriethoxysilane, benzyltriethoxysilane, 6-triethoxysilyl-2-norbornane, octyltriethoxysilane, 3-(triethoxysilylpropyl)-p-nitrobenzamide, dodecyltriethoxysilane, octadecyltriethoxysilane, allyltriethoxysilane, 3-glycidoxypropyltriethoxysilane, 3-methacryloxypropyltriethoxysilane, 3-(aminoethylaminopropyl) triethoxysilane, methyltripropoxysilane, vinyltris(2-methoxyethoxy)silane, 3-glycidoxypropylmethyldiethoxysilane, 3-methacryloxypropylmethyldimethoxysilane, 3-methacryloxypropylmethyldiethoxysilane and 3-(aminoethylaminopropyl)methyldimethoxysilane etc. In addition, while silicones having hydrolytic groups, among structures of silazanes and their condensates or other derivatives, chlorosilanes and their condensates or other derivatives, alkoxysilanes and their condensates or other derivatives, etc. are generally not classified as silane coupling agents, they may also be used according to the invention. As examples of titanate coupling agents there may be mentioned neopentyl(diallyl)oxytri(dioctyl)pyrophosphate titanate, etc. As examples of zirconate coupling agents there may be mentioned cyclo(dioctyl)pyrophosphate dioctylzirconate, etc. As examples of aluminum coupling agents there may be mentioned acetoalkoxyaluminum diisopropylate, etc. As examples of phosphate coupling agents there may be mentioned dibutyl-2-metallyloyloxy diethylphosphate, etc. Among these, silane coupling agents are most often used industrially for their advantages in terms of cost, abundance of different types and ready availability. Alkoxy-based silanes are preferred among these silane coupling agents, and as examples there may be mentioned vinyltrimethoxysilane, vinyltriethoxysilane, 2-(3,4-epoxycyclohexyl)ethyltrimethoxysilane, 3-glycidoxypropyltrimethoxysilane, 3-glycidoxypropyltriethoxysilane, 3-glycidoxypropylmethyldiethoxysilane, 3-methacryloxypropyltrimethoxysilane, 3-methacryloxypropyltriethoxysilane, 3-methacryloxypropylmethyldimethoxysilane, 3-methacryloxypropylmethyldiethoxysilane, 3-aminopropyltrimethoxysilane, 2-aminoethylaminomethyltrimethoxysilane, 3-(aminoethylaminopropyl) trimethoxysilane, 3-[2-(2-aminoethylaminoethylamino)propyl] trimethoxysilane, 3-phenylaminopropyltrimethoxysilane, 3-cyclohexylaminopropyltrimethoxysilane, 3-benzylaminopropyltrimethoxysilane, 3-aminopropyltriethoxysilane, 2-(2-aminoethylthioethyl)triethoxysilane, 3-(aminoethylaminopropyl) triethoxysilane, 3-(aminoethylaminopropyl)methyldimethoxysilane, 3-chloropropyltrimethoxysilane, 3-chloropropyltriethoxysilane, mercaptomethyltrimethoxysilane and 3-mercaptopropyltrimethoxysilane. Silane coupling agents with amino groups, such as 3-(aminoethylaminopropyl)methyldimethoxysilane, 3-(aminoethylaminopropyl)trimethoxysilane, 3-(aminoethylaminopropyl)triethoxysilane, 3-aminopropyltrimethoxysilane, 3-aminopropyltriethoxysilane, etc., have high stability in aqueous solutions and are therefore most advantageous for use in the polishing material slurry of the invention wherein water is the dispersing medium.

The appropriate amount of these coupling agents to be used will depend on the type of coupling agent, the method of surface treatment and the properties of the cerium oxide target of the surface treatment, but it is preferably 0.001 to 5 wt%, and more preferably 0.01 to 1 wt%, with respect to the cerium oxide. At less than 0.001 wt% it will be difficult to achieve improvement in compatibility between the cerium oxide and the pad. At greater than 5 wt%, however, the water repellency of the cerium oxide may make suspension in water impossible, and since the coupling agent will have a stronger effect at blocking direct contact between the working target and the cerium oxide, this may result in a lower polishing rate.

According to the invention, the surface treatment method using the coupling agent is not particularly restricted. A common industrially established method may be used, such as a dry method which involves atomizing a solution of the coupling agent with dry air or nitrogen while vigorously agitating the cerium oxide with a V-shaped blender to accomplish adequate mixing, and then carrying out heat treatment at about 100 to about 200°C for condensation reaction on the cerium oxide surface, or a wet method which involves dispersing the cerium oxide in water, etc. to form a slurry and adding a solution of the coupling agent, achieving solid/liquid separation and then drying at about 100-200°C. According to the invention it is also possible to eliminate the heat treatment at about 100 to about 200°C which is usually carried out for surface treatment by common coupling agents. That is, the surface treatment with the coupling agent will have an effect even if a prescribed amount of the coupling agent is simply mixed with a slurry of the cerium oxide suspended in water.

As mentioned above, the polishing-material slurry of the invention is obtained by dispersing cerium oxide subjected to prior surface treatment with a coupling agent in water, which is preferably purified water. Since a particular effect is exhibited by abrasive grain surface treatment with the coupling agent even if a prescribed amount of the coupling agent is mixed with a polishing-material composition comprising a slurry of cerium oxide suspended in water, this may also be used as the polishing-material slurry of the invention. The method of dispersing the inorganic compound is not particularly restricted, and a publicly known dispersing machine such as a common stirrer, homomixer, turbine mixer, media agitation mill or the like may be used. During the dispersion, a publicly known dispersing agent may also be added which is considered appropriate for aqueous slurries, such as a polycarboxylate, naphthalenesulfonate formalin condensate, etc. Coarse aggregated particles may be removed by precipitation sorting or filtration.

The polishing-material slurry of the invention may also contain various additives that are publicly known in the field, such as viscosity adjusters, pH regulators, buffering agents, chelating agents, surfactants, organic acids and their salts, etc.

According to the invention, the concentration of the cerium oxide that is surface treated with the coupling agent will depend on the polishing conditions including the working pressure during polishing, the type and amount of coupling agent used, and the method of surface treatment, but it is 0.3 to 10 wt%. At less than 0.01 wt%, the polishing rate will be lower for insulating films including silicon dioxide films, silicon nitride films and organic films, while at greater than 10 wt% there will be little improvement by the increased amount, i.e. little improvement in the polishing rate for insulating films including silicon dioxide films, silicon nitride films and organic films, and it is therefore not economically desirable.

The suitable pH for polishing with the polishing-material slurry of the invention will now be explained.

For polishing a silicon dioxide film, the pH is preferably 2 to 11 and more preferably 4 - 10, although it will depend on the type and amount of the coupling agent used and the method of surface treatment. If the pH is less than 2 the polishing rate for silicon dioxide will be lower, and if the pH is greater than 11 the polishing rate for silicon dioxide will likewise be lower.

On the other hand, for polishing a silicon nitride film, the polishing rate will usually be reduced when the pH is in the neutral range or near-neutral range, although it will depend on the type and amount of the coupling agent used and the method of surface treatment.

The polishing-material slurry of the invention can also be suitably used in the shallow trench isolation method which requires a high "selectivity ratio" which is the value of the polishing rate for the silicon dioxide film divided by that for the silicon nitride film. Since the pH dependency differs for the polishing rate for the silicon dioxide film and the polishing rate for the silicon nitride film, a pH range exists where the "selectivity ratio" is increased. In order to attain a high selectivity ratio, the pH is preferably 4 - 11 and more preferably 5 - 10, although it will depend on the type and amount of the coupling agent used and the method of surface treatment.

When an even higher selectivity ratio is necessary in the Shallow Trench Isolation method or the like, it is effective to add to the polishing-material slurry of the invention one or more organic acids and their salts, and especially water-soluble organic compounds having at least one from -COOH groups, -COOMₓ groups (where Mₓ is an atom or functional group that can be substituted to an H atom to form a salt), -SO₃H groups and -SO₃M_{y} groups (where M_{y} is an atom or functional group that can substitute for an H atom to form a salt).

Of these water-soluble organic compounds, lactic acid, malic acid, tartaric acid, succinic acid, gluconic acid, aspartic acid, glutamic acid, 6-aminohexanoic acid, 2,7-naphthalenedisulfonic acid and 2-aminoethanesulfonic acid are preferred for use, because they allow a high selection ratio to be obtained without in any way impairing the improvement in affinity between the abrasive grains and the pad, which is the most important effect of the invention.

The amount of the water-soluble organic compound to be added is preferably in the range of 0.001-10 parts by weight, and more preferably 0.005 to 5 parts by weight, to 1 part by weight of the cerium oxide. At less than 0.001 part by weight it is difficult to obtain an effect of an improved selection ratio by addition of the water-soluble organic compound, and at greater than 10 parts by weight a minimal increase in effect results from the increased amount, which is not economical.

An even higher selectivity ratio can be obtained by appropriate adjustment of the pH after addition of the water-soluble organic compound. When it is desired to lower the pH, an inorganic acid such as nitric acid, hydrochloric acid or sulfuric acid, an organic acid such as malic acid, lactic acid, tartaric acid, gluconic acid, citric acid monohydrate, succinic acid, adipic acid or fumaric acid, or an acidic amino acid such as aspartic acid or glutamic acid may be used. If instead it is desired to increase the pH, ammonia or an amine such as ethanolamine, or a neutral or basic amino acid such as glycine, 4-aminobutyric acid, 6-aminohexanoic acid, 12-aminolauric acid, alginic acid or glycylglycine may be used.

### Examples

The present invention will now be explained in greater detail by way of examples.

### Example 1

With 1000 g of high-purity cerium oxide slurry (GPL-C1010 by Showa Denko, KK., 10 wt% concentration of cerium oxide with d₅₀ = 0.5 µm, primary particle size = 0.1 µm, purity = 99.9 wt%) there was mixed 0.5 g of a silane coupling agent (A-1120 by Nihon Unica, KK., 3-(aminoethylaminopropyl)trimethoxysilane), and after stirring for 20 hours with a common stirrer, the solid portion was filtered out and dried at 150°C for 2 hours to obtain 100 g of cerium oxide fine powder surface-treated with a silane coupling agent. Here, the amount of the silane coupling agent was 0.5 wt% with respect to the cerium oxide fine powder.

A 100 g of the cerium oxide fine powder obtained in this manner was dispersed in purified water using a common stirrer, to produce a cerium oxide slurry in a total amount of 10,000 g. The cerium oxide concentration was 1 wt%, and the pH was 5.1.

The following method was used to evaluate the polishing performance of the cerium oxide slurry on a silicon dioxide film and a silicon nitride film.

### [Polishing conditions]

### Polishing target:

(1) Silicon dioxide film (approximately 1 µm film thickness) formed on a 6" φ, 625 µm thick silicon wafer by CVD.
(2) Silicon nitride film (approximately 0.5 µm film thickness) formed on a 6" φ, 625 µm thick silicon wafer by CVD.
   - Pad:: Two-layer type LSI device polishing pad (IC1000/Suba400 by Rodel, Inc.)
   - Polishing machine:: Single-side polishing machine for LSI device polishing (Model SH-24 by SpeedFam Co., Ltd., table diameter: 610 mm)
   - Table rotation speed:: 70 rpm
   - Working pressure:: 300 gf/cm²
   - Slurry-supply rate:: 100 ml/min
   - Polishing time:: 10 sec, 60 sec

### [Evaluated parameters and evaluation method]

- Polishing rate:: Light interference film thickness measuring apparatus (calculated by dividing the amount of removal by the polishing time)
- Imperfections:: Dark-field observation with optical microscope (determined by observing 3% of the wafer surface at 200 times and counting the number of detected imperfections per wafer)

As a result of the above polishing test, the polishing rate for silicon dioxide was found to be a very high value of 870 nm/min (8700 Å/min) for a polishing time of 10 seconds and 835 nm/min (8350 Å/min) for a polishing time of 60 seconds, and therefore the polishing rate for 10 seconds was 104% of that for 60 seconds. The polishing rate for silicon nitride was also a very high value of 140 nm/min (1400 Å/min) for a polishing time of 10 seconds and 135 nm/min (1350 Å/min) for a polishing time of 60 seconds, and therefore the polishing rate for 10 seconds was 104% of that for 60 seconds. It was therefore shown that the polishing rate for both silicon dioxide films and silicon nitride films was stable at a high level at the very initial stage of polishing. Also, absolutely no imperfections were found in the polished surfaces.

### Example 2

Ammonia water was added to the cerium oxide slurry obtained in Example 1 to adjust it to pH 8.8, and the polishing performance was evaluated in the same manner as Example 1.

The polishing rate for silicon dioxide was found to be a very high value of 740 nm/min (7400 Å/min) for a polishing time 10 seconds and 720 nm/min (7200 Å/min) for a polishing time of 60 seconds, and therefore the polishing rate for 10 seconds was 103% of that for 60 seconds. However, the polishing rate for silicon nitride was a low value of 13.5 nm/min (135 Å/min) for a polishing time of 10 seconds and 13.0 nm/min (1.30 Å/min) for a polishing time of 60 seconds, and the polishing rate for 10 seconds was 104% of that for 60 seconds. In this case, the polishing rate for silicon dioxide films was stable at a high level, while that for the silicon nitride films was stable at a low level. The "selectivity ratio" for 60 seconds was therefore a high value of 55, which is suitable for use in the Shallow Trench Isolation method.

### Comparative Example 1

Fumed silica slurry (SC-1, 30 wt%) by Cabot Co. was diluted with purified water to produce a 10 wt% slurry at pH 10.3, and the polishing performance thereof was evaluated in the same manner as Example 1.

The polishing rate for silicon dioxide was found to be 98 nm/min (980 Å/min) for a polishing time of 10 seconds and 161 nm/min (1610 Å/min) for a polishing time of 60 seconds, and therefore the polishing rate for 10 seconds was 61% of that for 60 seconds. The polishing rate for silicon nitride was 24 nm/min (240 Å/min) for a polishing time of 10 seconds and 41 nm/min (410 Å/min) for a polishing time of 60 seconds, and therefore the polishing rate for 10 seconds was 59% of that for 60 seconds. The polishing rate for both silicon dioxide films and silicon nitride films was at a low level, and the polishing rate was also strongly time-dependent. Also, the "selectivity ratio" for 60 seconds was a low value of 3.9. No imperfections were detected from the polished side.

### Comparative Example 2

The high-purity cerium oxide slurry "GPL-C1010" was diluted 10-fold with purified water to produce a slurry at pH 7.0 with a concentration of 1 wt% cerium oxide which was not surface treated with a silane coupling agent, and the polishing performance thereof was evaluated in the same manner as Example 1.

The polishing rate for silicon dioxide was found to be 415 nm/min (4150 Å/min) for a polishing time of 10 seconds and 610 nm/min (6100 Å/min) for a polishing time of 60 seconds, and therefore the polishing rate for 10 seconds was 68% of that for 60 seconds. The polishing rate for silicon nitride was 68 nm/min (680 Å/min) for a polishing time of 10 seconds and 105 nm/min (1050 Å/min) for a polishing time of 60 seconds, and therefore the polishing rate for 10 seconds was 65% of that for 60 seconds. It was therefore demonstrated that the polishing rate for both silicon dioxide films and silicon nitride films was at a lower level than when surface treatment was carried out with a silane coupling agent, the polishing rate being particularly low during the initial polishing, showing strong time dependence of the polishing rate. Also, the "selectivity ratio" for 60 seconds was a low value of 5.8. Absolutely no imperfections were detected from the polished side.

### Comparative Example 3

Fumed silica slurry (SC-1, 30 wt%) by Cabot Co. was diluted with purified water to produce a 10 wt% slurry, and surface treatment by the same method as Example 1 yielded 100 g of silane coupling agent-surface treated silica fine powder.

The 100 g of silica fine powder thus obtained was dispersed in purified water using a media agitation mill, KOH was then added to produce 1000 g of a silica slurry with a silica concentration of 10 wt% and a pH of 10.3, and the polishing performance thereof was evaluated in the same manner as Example 1.

The polishing rate for silicon dioxide was found to be 105 nm/min (1050 Å/min) for a polishing time of 10 seconds and 157 nm/min (1570 Å/min) for a polishing time of 60 seconds, and therefore the polishing rate for 10 seconds was 67% of that for 60 seconds. The polishing rate for silicon nitride was 24 nm/min (240 Å/min) for a polishing time of 10 seconds and 42 nm/min (420 Å/min) for a polishing time of 60 seconds, and therefore the polishing rate for 10 seconds was 57% of that for 60 seconds. The polishing rate for both silicon dioxide films and silicon nitride films was a low level, and the polishing rate was strongly time-dependent. Also, the "selectivity ratio" for 60 seconds was a low value of 3.7. These results were virtually the same as in the case with no surface treatment with a silane coupling agent. The polished surface was found to have 600 imperfections per wafer.

### Comparative Example 4

A manganese dioxide reagent (MnO₂ by Wako Pure Chemical Industries, Ltd., purity = 99.5%) was pulverized and subjected to precipitation sorting using purified water to produce a 10 wt% manganese dioxide slurry adjusted to d₆₀ = 0.7 µm, and the polishing performance thereof was evaluated in the same manner as Example 1.

The polishing rate for silicon dioxide was found to be 134 nm/min (1340 Å/min) for a polishing time of 10 seconds and 217 nm/min (2170 Å/min) for a polishing time of 60 seconds, and therefore the polishing rate for 10 seconds was 62% of that for 60 seconds. The polishing rate for silicon nitride was 44 nm/min (440 Å/min) for a polishing time of 10 seconds and 75 nm/min (750 Å/min) for a polishing time of 60 seconds, and therefore the polishing rate for 10 seconds was 59% of that for 60 seconds. The polishing rate for both silicon dioxide films and silicon nitride films was a low level, and the polishing rate was strongly time-dependent. Also, the "selectivity ratio" for 60 seconds was a low value of 2.9. The polished surface was found to have 400 imperfections per wafer.

### Comparative Example 5

The manganese dioxide slurry obtained in Comparative Example 4 was used to produce a slurry suspended manganese dioxide surface-treated with a silane coupling agent (manganese dioxide concentration: 10 wt%) by the same method as Example 1, and the polishing performance thereof was evaluated in the same manner as Example 1.

The polishing rate for silicon dioxide was found to be 148 nm/min (1480 Å/min) for a polishing time of 10 seconds and 231 nm/min (2310 Å/min) for a polishing time of 60 seconds, and therefore the polishing rate for 10 seconds was 64% of that for 60 seconds. The polishing rate for silicon nitride was 49 nm/min (490 Å/min) for a polishing time of 10 seconds and 78 nm/min (780 Å/min) for a polishing time of 60 seconds, and therefore the polishing rate for 10 seconds was 63% of that for 60 seconds. The polishing rate for both silicon dioxide films and silicon nitride films was a low level, and the polishing rate was strongly time-dependent. Also, the "selectivity ratio" for 60 seconds was a low value of 3.0. These results were virtually the same as in the case with no surface treatment with a silane coupling agent. The polished surface was found to have 630 imperfections per wafer.

The evaluation of the polishing performance for Examples 1-2 and Comparative Examples 1-5 is summarized in Table 1.

**Table 1**

| Sample | Silicon oxide film polishing rate (nm/min) | | Silicon nitride film polishing rate (nm/min) | | Stability of silicon oxide film polishing rate* | Selectivity ratio for 60 seconds of polishing** |
|---|---|---|---|---|---|---|
| | 10 secs of polishing | 60 secs of polishing | 10 secs of polishing | 60 secs of polishing | | |
| Example 1 | 870 | 835 | 140 | 135 | 104 | 6.2 |
| Example 2 | 740 | 720 | 13.5 | 13 | 103 | 55.4 |
| Comp.Ex. 1 | 98 | 161 | 24 | 41 | 61 | 3.9 |
| Comp.Ex. 2 | 415 | 610 | 68 | 105 | 68 | 5.8 |
| Comp.Ex. 3 | 105 | 157 | 24 | 42 | 67 | 3.7 |
| Comp.Ex. 4 | 134 | 217 | 44 | 75 | 62 | 3.0 |
| Comp.Ex. 5 | 148 | 231 | 49 | 78 | 64 | 3.0 |

| | | | | | | |
|---|---|---|---|---|---|---|
| *(polishing rate (10 secs) for silicon oxide film)/(polishing rate (60 secs) for silicon oxide film) x 100 (%) ** (polishing rate (60 secs) for silicon oxide film)/(polishing rate (60 secs) for silicon nitride film) | | | | | | |

### Example 3

The step-reducing performance on the silicon dioxide film by the cerium oxide slurry obtained in Example 1 was evaluated by the following method.

### [Polishing conditions]

- Polishing target:: CVD silicon dioxide film with a model pattern for evaluation of step-reducing performance on a 6" φ, 625 µm thick silicon wafer (approximately 1.55 µm film thickness at raised sections, approximately 1 µm film thickness at depressed sections, step: approximately 0.55 µm, pattern size: 0.6 µm - 4000 µm)
- Pad:: Two-layer type LSI device polishing pad (IC1000/Suba400 by Rodel, Inc.)
- Polishing machine:: Single-side polishing machine for LSI device polishing (Model SH-24 by SpeedFam, Co., Ltd., table diameter: 610 mm)
- Table rotation speed:: 70 rpm
- Working pressure:: 300 gf/cm²
- Slurry-supplied rate:: 100 ml/min
- Polishing time:: 60 sec

### [Evaluated parameters and evaluation method]

- Measured pattern size:: 0.6 µm, 100 µm, 4000 µm
- Step measurement:: Stylus-type surface shape measuring apparatus (Step of target pattern measured after polishing)

The results are shown in Table 2.

### Comparative Example 6

The step-reducing performance on silicon dioxide film by the silica slurry obtained in Comparative Example 1 was evaluated by the same method as Example 3.

The results are shown in Table 2.

### Comparative Example 7

The step-reducing performance on silicon dioxide film by the cerium oxide slurry obtained in Comparative Example 2 was evaluated by the same method as Example 3.

The results are shown pin Table 2.

**Table 2**

| No. | Composition | Step after polishing (nm) | | |
|---|---|---|---|---|
| | | 0.6 µm | 100 µm | 4000 µm |
| Example 3 | 1.0 wt% cerium oxide treated with silane coupling agent | 20 | 30 | 140 |
| Comp.Ex. 6 | 10 wt% silica | 260 | 280 | 440 |
| Comp.Ex. 7 | 1.0 wt% cerium oxide | 170 | 210 | 370 |

### Example 4

Coupling agent-treated cerium oxide fine powder was produced by the same method as Example 1 and suspended in different water-soluble organic solutions adjusted to appropriate pH values, to obtain the polishing-material slurries listed in Table 3. Their polishing performance was evaluated in the same manner as Example 1. The results are summarized in Table 4.

**Table 3**

| No. | Polishing slurry | pH |
|---|---|---|
| 1 | 1 wt% silane coupling agent-treated cerium oxide, 1 wt% lactic acid, adjusted to pH 7 with ammonia water | 7.0 |
| 2 | 1 wt% silane coupling agent-treated cerium oxide, 2 wt% lactic acid, adjusted to pH 7 with ammonia water | 7.0 |
| 3 | 1 wt% silane coupling agent-treated cerium oxide, 3 wt% lactic acid, adjusted to pH 7 with ammonia water | 7.0 |
| 4 | 1 wt% silane coupling agent-treated cerium oxide, 2 wt% malic acid, adjusted to pH 7 with ammonia water | 7.0 |
| 5 | 1 wt% silane coupling agent-treated cerium oxide, 2 wt% tartaric acid, adjusted to pH 7 with ammonia water | 7.0 |
| 6 | 1 wt% silane coupling agent-treated cerium oxide, 2 wt% succinic acid, adjusted to pH 7 with ammonia water | 7.0 |
| 7 | 1 wt% silane coupling agent-treated cerium oxide, 0.5 wt% gluconic acid, adjusted to pH 7 with ammonia water | 7.0 |
| 8 | 1 wt% silane coupling agent-treated cerium oxide, 200 ppm aspartic acid | 3.8 |
| 9 | 1 wt% silane coupling agent-treated cerium oxide, 500 ppm glutamic acid | 4.0 |
| 10 | 1 wt% silane coupling agent-treated cerium oxide, 1 wt% 6-aminohexanoic acid | 6.5 |
| 11 | 1 wt% silane coupling agent-treated cerium oxide, 1 wt% 2,7-naphthalenedisulfonic acid, adjusted to pH 7 with ammonia water | 7.0 |
| 12 | 1 wt% silane coupling agent-treated cerium oxide, 1 wt% 2-aminoethanesulfonic acid, adjusted to pH 7 with ammonia water | 7.0 |
| 13 | 1 wt% silane coupling agent-treated cerium oxide, 3 wt% lactic acid, 1 wt% 6-aminohexanoic acid, adjusted to pH 7 with ammonia water | 7.0 |

**Table 4**

| No. | Silicon oxide film polishing rate (nm/min) | | Silicon nitride film polishing rate (nm/min) | | Stability of silicon oxide film polishing seconds of rate* | Selectivity ratio for 60 polishing** |
|---|---|---|---|---|---|---|
| | 10 secs of polishing | 60 secs of polishing | 10 secs of polishing | 60 secs of polishing | | |
| 1 | 537 | 515 | none | 4.8 | 104 | 107 |
| 2 | 463 | 447 | none | 3.6 | 104 | 124 |
| 3 | 398 | 383 | none | 2.4 | 104 | 160 |
| 4 | 391 | 392 | none | 3.2 | 100 | 123 |
| 5 | 339 | 321 | none | 2.8 | 106 | 115 |
| 6 | 305 | 298 | none | 4.9 | 102 | 61 |
| 7 | 249 | 242 | none | 1.7 | 103 | 142 |
| 8 | 801 | 758 | none | 4.3 | 106 | 176 |
| 9 | 636 | 613 | none | 4.6 | 104 | 133 |
| 10 | 560 | 538 | none | 9.9 | 104 | 54 |
| 11 | 413 | 399 | none | 4.7 | 104 | 85 |
| 12 | 501 | 485 | none | 7.7 | 103 | 63 |
| 13 | 533 | 512 | none | 2.2 | 104 | 233 |

| | | | | | | |
|---|---|---|---|---|---|---|
| *(polishing rate (10 secs) for silicon oxide film)/(polishing rate (60 secs) for silicon oxide film) x 100 (%) ** (polishing rate (60 secs) for silicon oxide film)/(polishing rate (60 secs) for silicon nitride film) | | | | | | |

### Industrial Applicability

Because the polishing-material slurry of the invention contains cerium oxide had improved affinity for pads due to surface treatment with a coupling agent, it was therefore possible to realize a higher level of both surface accuracy and polishing rate, as well as stabilization of polishing rate in the polishing steps for insulating films including silicon dioxide films, silicon nitride films and organic films in manufacturing processes for LSI devices.

## Claims

1. A polishing-material slurry for polishing of LSI devices **characterized by** a polishing-material slurry comprising water and cerium oxide in a concentration of 0.3 to 10 wt.% which has been surface-treated with a coupling agent, the maximum value being no greater than 5 µm and the average value being 0.01 to 1.0 µm in the secondary particle size distribution of said cerium oxide.

2. A polishing-material slurry for polishing of LSI devices according to claim 1, **characterized in that** the primary crystal size of said cerium oxide is 0.005 to 0.5 µm.

3. A polishing-material slurry for polishing of LSI devices according to claim 1, **characterized in that** said coupling agent is at least one coupling agent selected from among silane coupling agents, titanate coupling agents, zirconate coupling agents, aluminum coupling agents and phosphate coupling agents.

4. A polishing-material slurry for polishing of LSI devices according to claim 1, **characterized in that** the pH is from 2 to 11.

5. A polishing-material slurry for polishing of LSI devices according to claim 1, **characterized in that** the pH is from 4 to 11, and when a silicon nitride film and a silicon dioxide film are each formed separately by CVD on a silicon substrate, the ratio of the polishing rate of the latter with respect to the former is at least 10 when each is polished independently and under the same conditions.

6. A polishing-material slurry for polishing of LSI devices according to claim 1, **characterized in that** when the polishing rate is defined as the amount of removal of the polishing target divided by the polishing time, the polishing rate for 10 seconds of polishing of the polishing target evenly formed on a silicon substrate is 80-120% of that for 60 seconds of polishing.

7. A polishing-material slurry for polishing of LSI devices according to claim 1, **characterized by** further containing one or more types of water-soluble organic compounds having at least one from among -COOH groups, -COOMₓ groups (where Mₓ is an atom or functional group that can be substituted for an H atom to form a salt), -SO₃H groups and -SO3M_{y} groups (where M_{y} is an atom or functional group that can be substituted for an H atom to form a salt).

8. A polishing-material slurry for polishing of LSI devices according to claim 7, **characterized in that** when a silicon nitride film and a silicon dioxide film are each formed separately by CVD on a silicon substrate, the ratio of the polishing rate of the latter with respect to the former is at least 50 when each is polished independently and under the same conditions.

9. A polishing method for LSI devices, which comprises a step of polishing an LSI device using a polishing pad made of resin and a polishing-material slurry comprising water and cerium oxide in a concentration of 0.3 to 10 wt% which has been surface-treated with a coupling agent, wherein the maximum value is no greater than 5 um and the average value is 0.01 to 1.0 µm in the secondary particle size distribution of said cerium oxide.

10. A polishing method for LSI devices according to claim 9, **characterized in that** the primary crystal size of said cerium oxide is 0.005 to 0.5 µm.

11. A polishing method for LSI devices according to claim 9, **characterized in that** said coupling agent is at least one coupling agent selected from among silane coupling agents, titanate coupling agents, zirconate coupling agents, aluminum coupling agents and phosphate coupling agents.

12. A polishing method for LSI devices according to claim 9, **characterized in that** the pH of said slurry composition is from 2 to 11.

13. A polishing method for LSI devices according to claim 9, **characterized in that** the LSI device has a silicon nitride film formed by CVD on a silicon substrate and a silicon dioxide film formed on the silicon nitride film by CVD, and the method comprises a step of polishing said silicon dioxide film using said polishing-material slurry, the pH of said slurry being 4 to 11, and using said silicon nitride as a stopper, wherein the ratio of the polishing rate for the silicon dioxide film to that for the silicon nitride film is 10 or greater.

14. A polishing method for LSI devices according to claim 9, **characterized in that** when the polishing rate is defined as the amount of removal of the polishing target divided by the polishing time, the polishing rate for 10 seconds of polishing of the polishing target evenly formed on a silicon substrate is 80-120% of that for 60 seconds of polishing.

15. A polishing method for LSI devices according to claim 9, **characterized in that** said slurry further contains one or more types of water-soluble organic compounds having at least one from among -COOH groups,-COOMₓ groups (where Mₓ is an atom or functional group that can be substituted for an H atom to form a salt),-SO₃H groups and -SO₃M_{Y} groups (where M_{Y} is an atom or functional group that can be substituted for an H atom to form a salt).

16. A polishing method for LSI devices according to claim 15, **characterized in that** the LSI device has a silicon nitride film formed by CVD on a silicon substrate and a silicon dioxide film formed on the silicon nitride film by CVD, and the method comprises a step of polishing said silicon dioxide film with said polishing-material slurry and using said silicon nitride as a stopper, wherein the ratio of the polishing rate for the silicon dioxide film to that for the silicon nitride film is 50 or greater.

## Patentansprüche

1. Eine Poliermaterialschlämme zum Polieren von LSI-Geräten, **gekennzeichnet durch** eine Poliermaterialschlämme, umfassend Wasser und Ceroxid in einer Konzentration von 0,3 bis 10 Gew.%, welche mit einem Haftvermittler oberflächenbehandelt wurde, wobei der Maximalwert in der sekundären Partikelgrößenverteilung des besagten Ceroxids nicht größer als 5 µm und der Durchschnittswert 0,01 bis 1,0 µm ist.

2. Eine Poliermaterialschlämme zum Polieren von LSI-Geräten nach Anspruch 1, **dadurch gekennzeichnet, dass** die primäre Kristallgröße des besagten Ceroxids 0,005 bis 0,5 µm ist.

3. Eine Poliermaterialschlämme zum Polieren von LSI-Geräten nach Anspruch 1, **dadurch gekennzeichnet, dass** besagter Haftvermittler zumindest ein Haftvermittler, ausgewählt aus Silanhaftvermittlern, Titanathaftvermittlern, Zirkonathaftvermittlern, Aluminiumhaftvermittlern und Phosphathaftvermittlern, ist.

4. Eine Poliermaterialschlämme zum Polieren von LSI-Geräten nach Anspruch 1, **dadurch gekennzeichnet, dass** der pH-Wert von 2 bis 11 ist.

5. Eine Poliermaterialschlämme zum Polieren von LSI-Geräten nach Anspruch 1, **dadurch gekennzeichnet, dass** der pH-Wert von 4 bis 11 ist, und, wenn ein Siliziumnitridfilm und ein Siliziumdioxidfilm jeweils separat von CVD auf einem Siliziumsubstrat gebildet werden, das Verhältnis der Polierrate des letzteren bezüglich des vorhergehenden zumindest 10 ist, wenn jeder unabhängig und unter den gleichen Bedingungen poliert wird.

6. Eine Poliermaterialschlämme zum Polieren von LSI-Geräten nach Anspruch 1, **dadurch gekennzeichnet, dass**, wenn die Polierrate als die Abtragmenge des Polierziels dividiert durch die Polierzeit definiert ist, die Polierrate für 10 Sekunden Polieren des Polierziels, gleichmäßig auf einem Siliziumsubstrat gebildet, 80-120% von derjenigen für 60 Sekunden Polieren beträgt.

7. Eine Poliermaterialschlämme zum Polieren von LSI-Geräten nach Anspruch 1, **gekennzeichnet durch** weiteres Umfassen einer oder mehrerer Art(en) von wasserlöslichen organischen Verbindungen mit zumindest einer von -COOH Gruppen, -COOMₓ Gruppen (wobei Mₓ ein Atom oder eine funktionelle Gruppe ist, das (die) für ein H-Atom substituiert werden kann, um ein Salz zu bilden), -SO₃H Gruppen und - SO₃M_{Y} Gruppen (wobei M_{Y} ein Atom oder eine funktionelle Gruppe ist, das (die) für ein H-Atom substituiert werden kann, um ein Salz zu bilden).

8. Eine Poliermaterialschlämme zum Polieren von LSI-Geräten nach Anspruch 7, **dadurch gekennzeichnet, dass**, wenn ein Siliziumnitridfilm und ein Siliziumdioxidfilm jeweils separat von CVD auf einem Siliziumsubstrat gebildet werden, das Verhältnis der Polierrate des letzteren bezüglich des vorhergehenden zumindest 50 ist, wenn jeder unabhängig und unter den gleichen Bedingungen poliert wird.

9. Ein Polierverfahren für LSI-Geräte, welches einen Schritt des Polierens eines LSI-Geräts unter Verwendung eines Polierpads aus Harz und einer Poliermaterialschlämme, umfassend Wasser und Ceroxid in einer Konzentration von 0,3 bis 10 Gew.%, welches bereits mit einem Haftvermittler oberflächenbehandelt wurde, umfasst, wobei der Maximalwert in der sekundären Partikelgrößenverteilung des besagten Ceroxids nicht größer als 5 µm und der Durchschnittswert 0,01 bis 1,0 µm ist.

10. Ein Polierverfahren für LSI-Geräte nach Anspruch 9, **dadurch gekennzeichnet, dass** die primäre Kristallgröße des besagten Ceroxids 0,005 bis 0,5 µm ist.

11. Ein Polierverfahren für LSI-Geräte nach Anspruch 9, **dadurch gekennzeichnet, dass** besagter Haftvermittler zumindest ein Haftvermittler, ausgewählt aus Silanhaftvermittlern, Titanathaftvermittlern, Zirkonathaftvermittlern, Aluminiumhaftvermittlern und Phosphathaftvermittlern, ist.

12. Ein Polierverfahren für LSI-Geräte nach Anspruch 9, **dadurch gekennzeichnet, dass** der pH-Wert der besagten Schlämmezusammensetzung von 2 bis 11 ist.

13. Ein Polierverfahren für LSI-Geräte nach Anspruch 9, **dadurch gekennzeichnet, dass** das LSI-Gerät einen durch CVD gebildeten Siliziumnitridfilm auf einem Siliziumsubstrat, und einen durch CVD gebildeten Siliziumdioxidfilm auf dem Siliziumnitridfilm, aufweist, und das Verfahren einen Schritt des Polierens des besagten Siliziumdioxidfilms unter Verwendung besagter Poliermaterialschlämme umfasst, wobei der pH-Wert der besagten Schlämme 4 bis 11 ist und besagtes Siliziumnitrid als ein Stopper verwendet wird, wobei das Verhältnis der Polierrate für den Siliziumdioxidfilm zu dem für den Siliziumnitridfilm 10 oder größer ist.

14. Ein Polierverfahren für LSI-Geräte nach Anspruch 9, **dadurch gekennzeichnet, dass**, wenn die Polierrate als die Abtragsmenge des Polierziels dividiert durch die Polierzeit definiert ist, die Polierrate für 10 Sekunden Polieren des Polierziels, gleichmäßig gebildet auf einem Siliziumsubstrat, 80-120% derjenigen für 60 Sekunden Polieren beträgt.

15. Ein Polierverfahren für LSI-Geräte nach Anspruch 9, **dadurch gekennzeichnet, dass** besagte Schlämme weiters eine oder mehreren Art(en) von wasserlöslichen organischen Verbindungen mit zumindest einer von -COOH Gruppen, -COOMₓ Gruppen (wobei Mₓ ein Atom oder eine funktionelle Gruppe ist, das (die) für ein H-Atom substituiert werden kann, um ein Salz zu bilden), -SO₃H Gruppen und -SO₃M_{Y} Gruppen (wobei M_{Y} ein Atom oder eine funktionelle Gruppe ist, das (die) für ein H-Atom substituiert werden kann, um ein Salz zu bilden) umfasst.

16. Ein Polierverfahren für LSI-Geräte nach Anspruch 15, **dadurch gekennzeichnet, dass** das LSI-Gerät einen Siliziumnitridflm, gebildet durch CVD auf einem Siliziumsubstrat, und einen Siliziumdioxidfilm, gebildet auf dem Siliziumnitridfilm durch CVD, aufweist, und das Verfahren einen Schritt des Polierens des besagten Siliziumdioxidfilms mit besagter Poliermaterialschlämme umfasst, und besagtes Siliziumnitrid als ein Stopper verwendet wird, wobei das Verhältnis der Polierrate für den Siliziumdioxidfilm zu der für den Siliziumnitridfilm 50 oder größer ist.

## Revendications

1. Pâte pour produit à polir destinée au polissage de dispositifs LSI, **caractérisée en ce qu'**une pâte pour produit à polir comprenant de l'eau et de l'oxyde de cérium à une concentration de 0,3 à 10 % en poids a été traitée en surface avec un agent de couplage, dont la valeur maximale ne dépassant pas 5 µm et la valeur moyenne allant de 0,01 1 à 1,0 µm dans la répartition granulométrique secondaire dudit oxyde de cérium.

2. Pâte pour produit à polir destinée au polissage de dispositifs LSI selon la revendication 1, **caractérisée en ce que** la taille du cristal primaire dudit oxyde de cérium va de 0,005 à 0,5 µm.

3. Pâte pour produit à polir destinée au polissage de dispositifs LSI selon la revendication 1, **caractérisée en ce que** ledit agent de couplage est au moins un agent de couplage sélectionné parmi les agents de couplage au silane, les agents de couplage au titanate, les agents de couplage au zirconate, les agents de couplage à l'aluminium et les agents de couplage au phosphate.

4. Pâte pour produit à polir destinée au polissage de dispositifs LSI selon la revendication 1, **caractérisée en ce que** le pH va de 2 à 11.

5. Pâte pour produit à polir destinée au polissage de dispositifs LSI selon la revendication 1, **caractérisée en ce que** le pH va de 4 à 11 et lorsqu'un film de nitrure de silicium et un film de dioxyde de silicium sont formés chacun séparément par dépôt chimique en phase vapeur (CVD - *Chemical Vapor Deposition*) sur un substrat de silicium, le rapport de la vitesse de polissage de ce dernier par rapport au premier est au moins de 10 lorsque chacun est poli indépendamment et sous les mêmes conditions.

6. Pâte pour produit à polir destinée au polissage de dispositifs LSI selon la revendication 1, **caractérisée en ce que** lorsque la vitesse de polissage est définie comme la quantité de la cible de polissage retirée, divisée par le temps de polissage, la vitesse de polissage pour 10 secondes de polissage de la cible de polissage formée uniformément sur un substrat de silicium est de 80 à 120 % de celle pour 60 secondes de polissage.

7. Pâte pour produit à polir destinée au polissage de dispositifs LSI selon la revendication 1, **caractérisée en ce qu'**elle contient, en outre, un ou plusieurs types de composés organiques hydrosolubles possédant au moins l'un parmi les groupes -COOH, les groupes -COOMₓ (où Mₓ est un atome ou un groupe fonctionnel qui peut être remplacé par un atome H pour former un sel), les groupes -SO3H et les groupes -SO3M_{y} (où M_{y} est un atome ou un groupe fonctionnel qui peut être remplacé par un atome H pour former un sel).

8. Pâte pour produit à polir destinée au polissage de dispositifs LSI selon la revendication 7, **caractérisée en ce que** lorsqu'un film de nitrure de silicium et un film de dioxyde de silicium sont formés chacun séparément par CVD sur un substrat de silicium, le rapport de la vitesse de polissage de ce dernier par rapport au premier est au moins de 50 lorsque chacun est poli indépendamment et sous les mêmes conditions.

9. Procédé de polissage des dispositifs LSI, qui comprend une étape de polissage d'un dispositif LSI en utilisant un tampon à polir fabriqué en résine et une pâte pour produit à polir comprenant de l'eau et de l'oxyde de cérium à une concentration de 0,3 à 10 % en poids qui a été traitée en surface avec un agent de couplage, dans lequel la valeur maximale ne dépasse pas 5 µm et la valeur moyenne va de 0,01 à 1,0 µm dans la répartition granulométrique secondaire dudit oxyde de cérium.

10. Procédé de polissage des dispositifs LSI selon la revendication 9, **caractérisé en ce que** la taille du cristal primaire dudit oxyde de cérium va de 0,005 à 0,5 µm.

11. Procédé de polissage des dispositifs LSI selon la revendication 9, **caractérisé en ce que** ledit agent de couplage est au moins un agent de couplage sélectionné parmi les agents de couplage au silane, les agents de couplage au titanate, les agents de couplage au zirconate, les agents de couplage à l'aluminium et les agents de couplage au phosphate.

12. Procédé de polissage des dispositifs LSI selon la revendication 9, **caractérisé en ce que** le pH de ladite composition pâteuse va de 2 à 11.

13. Procédé de polissage des dispositifs LSI selon la revendication 9, **caractérisé en ce que** le dispositif LSI possède un film de nitrure de silicium formé par CVD sur un substrat de silicium et un film de dioxyde de silicium formé sur le film de nitrure de silicium par CVD, et le procédé comprend une étape de polissage dudit film de dioxyde de silicium en utilisant ladite pâte pour produit à polir, le pH de ladite pâte allant de 4 à 11, et utilisant ledit nitrure de silicium comme un bouchon, dans lequel le rapport de la vitesse de polissage pour le film de dioxyde de silicium par rapport à celle pour le film de nitrure de silicium est supérieur ou égal à 10.

14. Procédé de polissage des dispositifs LSI selon la revendication 9, **caractérisé en ce que** lorsque la vitesse de polissage est définie comme la quantité de la cible de polissage retirée, divisée par le temps de polissage, la vitesse de polissage pour 10 secondes de polissage de la cible de polissage formée uniformément sur un substrat de silicium est de 80 à 120 % de celle pour 60 secondes de polissage.

15. Procédé de polissage des dispositifs LSI selon la revendication 9, **caractérisé en ce que** ladite pâte contient, en outre, un ou plusieurs types de composés organiques hydrosolubles possédant au moins l'un parmi les groupes -COOH, les groupes -COOMₓ (où Mₓ est un atome ou un groupe fonctionnel qui peut être remplacé par un atome H pour former un sel), les groupes -SO3H et les groupes -SO3M_{y} (où M_{y} est un atome ou un groupe fonctionnel qui peut être remplacé par un atome H pour former un sel).

16. Procédé de polissage des dispositifs LSI selon la revendication 15, **caractérisé en ce que** le dispositif LSI possède un film de nitrure de silicium formé par CVD sur un substrat de silicium et un film de dioxyde de silicium formé sur le film de nitrure de silicium par CVD, et le procédé comprend une étape de polissage dudit film de dioxyde de silicium en utilisant ladite pâte pour produit à polir et en utilisant ledit nitrure de silicium comme un bouchon, dans lequel le rapport de la vitesse de polissage pour le film de dioxyde de silicium par rapport à celle pour le film de nitrure de silicium est supérieur ou égal à 50.
